# EUROPEAN PATENT APPLICATION

(11) **EP 4 685 559 A2**
(43) Date of publication of application: **28.01.2026**
(21) Application number: 25221429.1
(22) Date of filing: 08.12.2025
(51) Int. Cl.: G03F 7/00

(54) **METHOD OF DETERMINING A CORRECTION AND/OR MITIGATION FOR A LITHOGRAPHIC EXPOSURE AND ASSOCIATED APPARATUS**

(71) Applicant: ASML Netherlands B.V., 5500 AH Veldhoven (NL)
(72) Inventor: HERMENS, Jacobus, Cornelis, Josephus, 5500 AH Veldhoven (NL); VAN DEN BROEKE, Jette, Janine, 5500 AH Veldhoven (NL); VAN DE RUIT, Kevin, 5500 AH Veldhoven (NL)
(74) Representative: ASML Netherlands B.V.

(57) **Abstract**

Disclosed is a method of determining a correction and/or mitigation for an effect of an exposure apparatus action of an exposure process on at least one exposure performance metric of the exposure process. The method comprises measuring aerial image data; performing at least one exposure apparatus action simultaneously with the step of measuring aerial image data, the exposure apparatus action comprising a movement of a component of the exposure apparatus and/or an initiation of a fluid flow within the exposure apparatus; correlating the aerial image data with the at least one exposure performance metric to obtain correlated aerial image data; and determining a correction and/or mitigation for the exposure process based on the correlated aerial image data.

## Description

### BACKGROUND

### Field of the Invention

The present invention relates to control apparatus and control methods usable, for example, to maintain performance in the manufacture of devices by patterning processes such as lithography. The invention further relates to methods of manufacturing devices using lithographic techniques. The invention yet further relates to computer program products for use in implementing such methods.

### Related Art

A lithographic process is one in which a lithographic apparatus applies a desired pattern onto a substrate, usually onto a target portion of the substrate, after which various processing chemical and/or physical processing steps work through the pattern to create functional features of a complex product. The accurate placement of patterns on the substrate is a chief challenge for reducing the size of circuit components and other products that may be produced by lithography. In particular, the challenge of positioning accurately the features on a substrate is a critical step in being able to position successive layers of features in superposition accurately enough to produce working devices with a high yield. So-called overlay should, in general, be achieved within a few tens of nanometers in today's sub-micron semiconductor devices, down to a few nanometers in the most critical layers. Also important to yield is accurate control of critical dimension (CD), i.e., the size of the features on the substrate.

The manufacturing processes may be for example lithography, etching, deposition, chemical mechanical planarization, oxidation, ion implantation, diffusion or a combination of two or more of them.

Certain dynamic actions performed on the exposure apparatus during the exposure can effect the quality of the exposure, e.g., can impact overlay and/or CD.

It is desirable to improve on present methods for correcting for this impact on overlay and/or CD.

### SUMMARY OF THE INVENTION

According to a first aspect of the present invention there is provided a method of determining a correction and/or mitigation for an effect of an exposure apparatus action of an exposure process on at least one exposure performance metric of the exposure process, comprising: measuring aerial image data relating to a position of an aerial image projected by a projection system of an exposure apparatus; performing at least one exposure apparatus action simultaneously with the step of measuring aerial image data, the exposure apparatus action comprising a movement of a component of the exposure apparatus and/or an initiation of a fluid flow within the exposure apparatus; correlating the aerial image data with the at least one exposure performance metric to obtain correlated aerial image data; and determining a correction and/or mitigation for the exposure process based on the correlated aerial image data.

According to a second aspect of the present invention there is provided a computer program product containing one or more sequences of machine-readable instructions for implementing calculating steps in a method according to the first aspect of the invention as set forth above

The invention yet further provides a processing arrangement and exposure apparatus comprising the computer program of the second aspect.

These and other aspects and advantages of the apparatus and methods disclosed herein will be appreciated from a consideration of the following description and drawings of exemplary embodiments.

### BRIEF DESCRIPTION OF THE DRAWINGS

Embodiments of the invention will now be described, by way of example only, with reference to the accompanying schematic drawings in which corresponding reference symbols indicate corresponding parts, and in which:
Figure 1 depicts a lithographic apparatus suitable for use in an embodiment of the present invention;
Figure 2 depicts a lithographic cell or cluster in which an inspection apparatus according to the present invention may be used; and
Figure 3 illustrates schematically measurement and exposure processes in the apparatus of

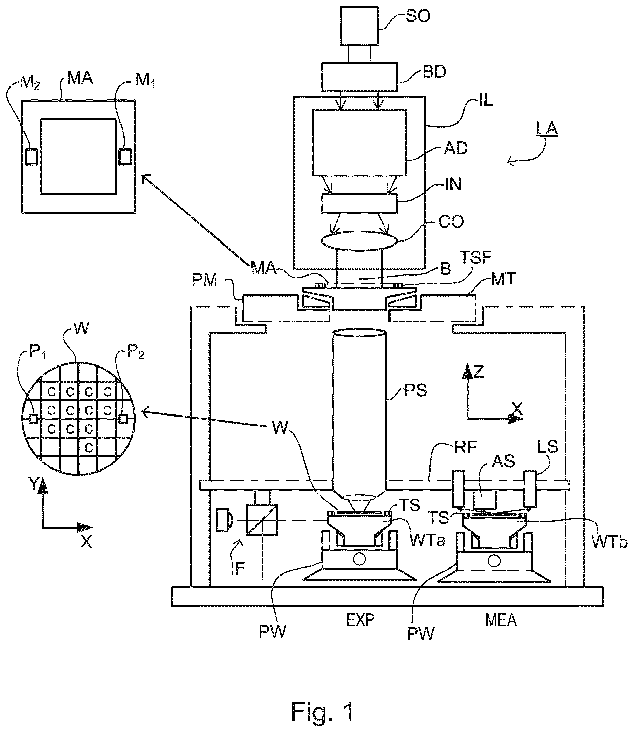

Figure 1, according to known practice;

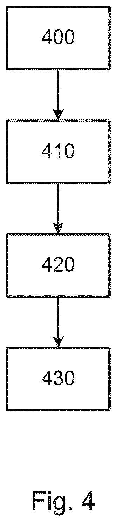

Figure 4 is a flowchart of a method according to concepts disclosed herein.

### DETAILED DESCRIPTION OF EXEMPLARY EMBODIMENTS

Before describing embodiments of the invention in detail, it is instructive to present an example environment in which embodiments of the present invention may be implemented.

Figure 1 schematically depicts an exposure apparatus (e.g., a lithographic apparatus) LA. The apparatus includes an illumination system (illuminator) IL configured to condition a radiation beam B (e.g., UV radiation or DUV radiation), a patterning device support or support structure (e.g., a mask table) MT constructed to support a patterning device (e.g., a mask) MA and connected to a first positioner PM configured to accurately position the patterning device in accordance with certain parameters; two substrate tables WTa and WTb (e.g., a substrate support or substrate/wafer table), each comprising a plurality of burls on a support surface and each constructed to hold a substrate (e.g., a resist coated wafer) W; and a projection system (e.g., a refractive projection lens system) PS configured to project a pattern imparted to the radiation beam B by patterning device MA onto a target portion C (e.g., including one or more dies) of the substrate W. Each substrate table may be connected to a second positioner PW configured to accurately position the substrate in accordance with certain parameters. A reference frame RF connects the various components, and serves as a reference for setting and measuring positions of the patterning device and substrate and of features on them.

The illumination system may include various types of optical components, such as refractive, reflective, magnetic, electromagnetic, electrostatic or other types of optical components, or any combination thereof, for directing, shaping, or controlling radiation. For example, in an apparatus using extreme ultraviolet (EUV) radiation, reflective optical components will normally be used.

The patterning device support holds the patterning device in a manner that depends on the orientation of the patterning device, the design of the exposure apparatus, and other conditions, such as for example whether or not the patterning device is held in a vacuum environment. The patterning device support can use mechanical, vacuum, electrostatic or other clamping techniques to hold the patterning device. The patterning device support MT may be a frame or a table, for example, which may be fixed or movable as required. The patterning device support may ensure that the patterning device is at a desired position, for example with respect to the projection system.

The term "patterning device" used herein should be broadly interpreted as referring to any device that can be used to impart a radiation beam with a pattern in its cross-section such as to create a pattern in a target portion of the substrate. It should be noted that the pattern imparted to the radiation beam may not exactly correspond to the desired pattern in the target portion of the substrate, for example if the pattern includes phase-shifting features or so called assist features. Generally, the pattern imparted to the radiation beam will correspond to a particular functional layer in a device being created in the target portion, such as an integrated circuit.

As here depicted, the apparatus is of a transmissive type (e.g., employing a transmissive patterning device). Alternatively, the apparatus may be of a reflective type (e.g., employing a programmable mirror array of a type as referred to above, or employing a reflective mask). Examples of patterning devices include masks, programmable mirror arrays, and programmable LCD panels. Any use of the terms "reticle" or "mask" herein may be considered synonymous with the more general term "patterning device." The term "patterning device" can also be interpreted as referring to a device storing in digital form pattern information for use in controlling such a programmable patterning device.

The term "projection system" used herein should be broadly interpreted as encompassing any type of projection system, including refractive, reflective, catadioptric, magnetic, electromagnetic and electrostatic optical systems, or any combination thereof, as appropriate for the exposure radiation being used, or for other factors such as the use of an immersion liquid or the use of a vacuum. Any use of the term "projection lens" herein may be considered as synonymous with the more general term "projection system".

The exposure apparatus may also be of a type wherein at least a portion of the substrate may be covered by a liquid having a relatively high refractive index, e.g., water, so as to fill a space between the projection system and the substrate. An immersion liquid may also be applied to other spaces in the exposure apparatus, for example, between the mask and the projection system. Immersion techniques are well known in the art for increasing the numerical aperture of projection systems.

In operation, the illuminator IL receives a radiation beam from a radiation source SO. The source and the exposure apparatus may be separate entities, for example when the source is an excimer laser. In such cases, the source is not considered to form part of the exposure apparatus and the radiation beam is passed from the source SO to the illuminator IL with the aid of a beam delivery system BD including, for example, suitable directing mirrors and/or a beam expander. In other cases the source may be an integral part of the exposure apparatus, for example when the source is a mercury lamp. The source SO and the illuminator IL, together with the beam delivery system BD if required, may be referred to as a radiation system.

The illuminator IL may for example include an adjuster AD for adjusting the angular intensity distribution of the radiation beam, an integrator IN and a condenser CO. The illuminator may be used to condition the radiation beam, to have a desired uniformity and intensity distribution in its cross section.

The radiation beam B is incident on the patterning device MA, which is held on the patterning device support MT, and is patterned by the patterning device. Having traversed the patterning device (e.g., mask) MA, the radiation beam B passes through the projection system PS, which focuses the beam onto a target portion C of the substrate W. With the aid of the second positioner PW and position sensor IF (e.g., an interferometric device, linear encoder, 2-D encoder or capacitive sensor), the substrate table WTa or WTb can be moved accurately, e.g., so as to position different target portions C in the path of the radiation beam B. Similarly, the first positioner PM and another position sensor (which is not explicitly depicted in Figure 1) can be used to accurately position the patterning device (e.g., mask) MA with respect to the path of the radiation beam B, e.g., after mechanical retrieval from a mask library, or during a scan.

Patterning device (e.g., mask) MA and substrate W may be aligned using mask alignment structures or alignment marks M1, M2 and substrate alignment structures or alignment marks P1, P2. Although the substrate alignment structures as illustrated occupy dedicated target portions, they may be located in spaces between target portions (these are known as scribe-lane alignment structures). Similarly, in situations in which more than one die is provided on the patterning device (e.g., mask) MA, the mask alignment structures may be located between the dies. Small alignment structures may also be included within dies, in amongst the device features, in which case it is desirable that the markers be as small as possible and not require any different imaging or process conditions than adjacent features. The alignment system, which detects the alignment structures, is described further below.

The depicted apparatus could be used in a variety of modes. In a scan mode, the patterning device support (e.g., mask table) MT and the substrate table WT are scanned synchronously while a pattern imparted to the radiation beam is projected onto a target portion C (i.e., a single dynamic exposure). The speed and direction of the substrate table WT relative to the patterning device support (e.g., mask table) MT may be determined by the (de-)magnification and image reversal characteristics of the projection system PS. In scan mode, the maximum size of the exposure field limits the width (in the non-scanning direction) of the target portion in a single dynamic exposure, whereas the length of the scanning motion determines the height (in the scanning direction) of the target portion. Other types of exposure apparatus and modes of operation are possible, as is well-known in the art. For example, a step mode is known. In so-called "maskless" lithography, a programmable patterning device is held stationary but with a changing pattern, and the substrate table WT is moved or scanned.

Combinations and/or variations on the above described modes of use or entirely different modes of use may also be employed.

Exposure apparatus LA is of a so-called dual stage type which has two substrate tables WTa, WTb and two stations - an exposure station EXP and a measurement station MEA - between which the substrate tables can be exchanged. While one substrate on one substrate table is being exposed at the exposure station, another substrate can be loaded onto the other substrate table at the measurement station and various preparatory steps carried out. This enables a substantial increase in the throughput of the apparatus. On a single stage apparatus, the preparatory steps and exposure steps need to be performed sequentially on the single stage, for each substrate. The preparatory steps may include mapping the surface height contours of the substrate using a level sensor LS and measuring the position of alignment structures on the substrate using an alignment sensor AS. If the position sensor IF is not capable of measuring the position of the substrate table while it is at the measurement station as well as at the exposure station, a second position sensor may be provided to enable the positions of the substrate table to be tracked at both stations, relative to reference frame RF. Other arrangements are known and usable instead of the dual-stage arrangement shown. For example, other exposure apparatuses are known in which a substrate table and a measurement table are provided. These are docked together when performing preparatory measurements, and then undocked while the substrate table undergoes exposure.

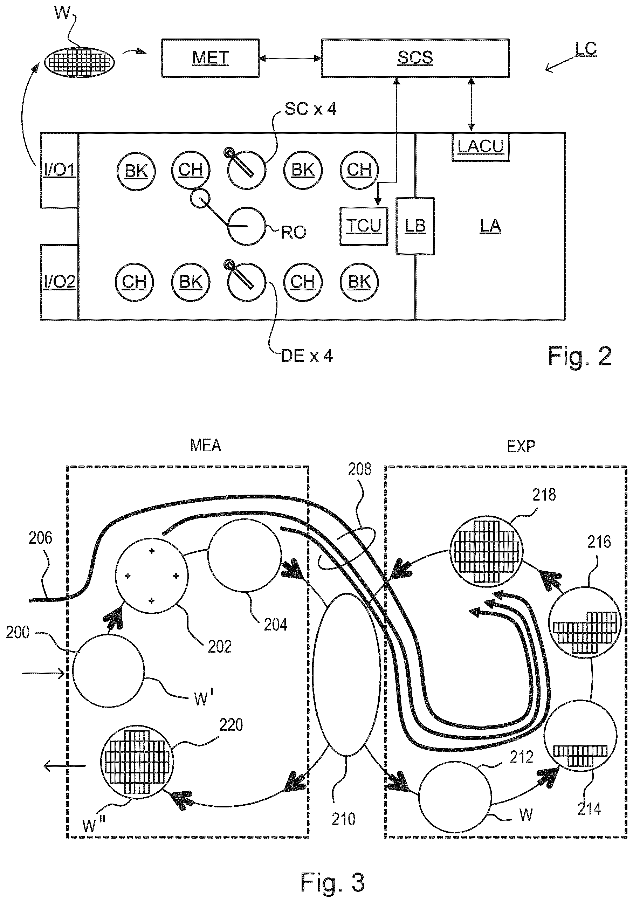

As shown in Figure 2, the exposure apparatus LA forms part of a lithographic cell LC, also sometimes referred to a lithocell or cluster, which also includes apparatus to perform pre- and post-exposure processes on a substrate. Conventionally these include spin coaters SC to deposit resist layers, developers DE to develop exposed resist, chill plates CH and bake plates BK. A substrate handler, or robot, RO picks up substrates from input/output ports I/O1, I/O2, moves them between the different process apparatus and delivers then to the loading bay LB of the exposure apparatus. These devices, which are often collectively referred to as the track, are under the control of a track control unit TCU which is itself controlled by the supervisory control system SCS, which also controls the exposure apparatus via lithography control unit LACU. Thus, the different apparatus can be operated to maximize throughput and processing efficiency.

In order that the substrates that are exposed by the exposure apparatus are exposed correctly and consistently, it is desirable to inspect exposed substrates to measure properties such as overlay between subsequent layers, line thicknesses, critical dimensions (CD), etc. Accordingly a manufacturing facility in which lithocell LC is located also includes metrology system MET which receives some or all of the substrates W that have been processed in the lithocell. Metrology results are provided directly or indirectly to the supervisory control system SCS. If errors are detected, adjustments may be made to exposures of subsequent substrates.

Within metrology system MET, an inspection apparatus is used to determine the properties of the substrates, and in particular, how the properties of different substrates or different layers of the same substrate vary from layer to layer. The inspection apparatus may be integrated into the exposure apparatus LA or the lithocell LC or may be a stand-alone device. To enable most rapid measurements, it may be desirable that the inspection apparatus measure properties in the exposed resist layer immediately after the exposure. However, not all inspection apparatus have sufficient sensitivity to make useful measurements of the latent image. Therefore measurements may be taken after the post-exposure bake step (PEB) which is customarily the first step carried out on exposed substrates and increases the contrast between exposed and unexposed parts of the resist. At this stage, the image in the resist may be referred to as semi-latent. It is also possible to make measurements of the developed resist image - at which point either the exposed or unexposed parts of the resist have been removed. Also, already exposed substrates may be stripped and reworked to improve yield, or discarded, thereby avoiding performing further processing on substrates that are known to be faulty. In a case where only some target portions of a substrate are faulty, further exposures can be performed only on those target portions which are good.

The metrology step with metrology system MET can also be done after the resist pattern has been etched into a product layer. The latter possibility limits the possibilities for rework of faulty substrates but may provide additional information about the performance of the manufacturing process as a whole.

Figure 3 illustrates the steps to expose target portions (e.g. dies) on a substrate W in the dual stage apparatus of Figure 1. The process according to conventional practice will be described first. The present disclosure is by no means limited to dual stage apparatus of the illustrated type. The skilled person will recognize that similar operations are performed in other types of exposure apparatus, for example those having a single substrate stage and a docking metrology stage.

On the left hand side within a dotted box are steps performed at measurement station MEA, while the right hand side shows steps performed at exposure station EXP. From time to time, one of the substrate tables WTa, WTb will be at the exposure station, while the other is at the measurement station, as described above. For the purposes of this description, it is assumed that a substrate W has already been loaded into the exposure station. At step 200, a new substrate W' is loaded to the apparatus by a mechanism not shown. These two substrates are processed in parallel in order to increase the throughput of the exposure apparatus.

Referring initially to the newly-loaded substrate W', this may be a previously unprocessed substrate, prepared with a new photo resist for first time exposure in the apparatus. In general, however, the lithography process described will be merely one step in a series of exposure and processing steps, so that substrate W' has been through this apparatus and/or other lithography apparatuses, several times already, and may have subsequent processes to undergo as well. Particularly for the problem of improving overlay performance, the task is to ensure that new patterns are applied in exactly the correct position on a substrate that has already been subjected to one or more cycles of patterning and processing. Each patterning step can introduce positional deviations in the applied pattern, while subsequent processing steps progressively introduce distortions in the substrate and/or the pattern applied to it that must be measured and corrected for, to achieve satisfactory overlay performance.

The previous and/or subsequent patterning step may be performed in other lithography apparatuses, as just mentioned, and may even be performed in different types of lithography apparatus. For example, some layers in the device manufacturing process which are very demanding in parameters such as resolution and overlay may be performed in a more advanced lithography tool than other layers that are less demanding. Therefore some layers may be exposed in an immersion type lithography tool, while others are exposed in a 'dry' tool. Some layers may be exposed in a tool working at DUV wavelengths, while others are exposed using EUV wavelength radiation. Some layers may be patterned by steps that are alternative or supplementary to exposure in the illustrated exposure apparatus. Such alternative and supplementary techniques include for example imprint lithography, self-aligned multiple patterning and directed self-assembly. Similarly, other processing steps performed per layer (e.g., CMP and etch) may be performed on different apparatuses per layer.

At 202, alignment measurements using the substrate marks P1 etc. and image sensors (not shown) are used to measure and record alignment of the substrate relative to substrate table WTa/WTb. In addition, several alignment structures across the substrate W' will be measured using alignment sensor AS. These measurements are used in one embodiment to establish a substrate model (sometimes referred to as the "wafer grid"), which maps very accurately the distribution of marks across the substrate, including any distortion relative to a nominal rectangular grid.

At step 204, a map of substrate height (Z) against X-Y position is measured also using the level sensor LS. Primarily, the height map is used only to achieve accurate focusing of the exposed pattern. It may be used for other purposes in addition.

When substrate W' was loaded, recipe data 206 were received, defining the exposures to be performed, and also properties of the substrate and the patterns previously made and to be made upon it. Where there is a choice of alignment structures on the substrate, and where there is a choice of settings of an alignment sensor, these choices are defined in an alignment recipe among the recipe data 206. The alignment recipe therefore defines how positions of alignment structures are to be measured, as well as which marks.

At 210, substrates W' and W are swapped, so that the measured substrate W' becomes the substrate W entering the exposure station EXP. In the example apparatus of Figure 1, this swapping is performed by exchanging the supports WTa and WTb within the apparatus, so that the substrates W, W' remain accurately clamped and positioned on those supports, to preserve relative alignment between the substrate tables and substrates themselves. Accordingly, once the tables have been swapped, determining the relative position between projection system PS and substrate table WTb (formerly WTa) is all that is necessary to make use of the measurement information 202, 204 for the substrate W (formerly W') in control of the exposure steps. At step 212, reticle alignment is performed using the mask alignment structures M1, M2. In steps 214, 216, 218, scanning motions and radiation pulses are applied at successive target locations across the substrate W, in order to complete the exposure of a number of patterns.

By using the alignment data and height map obtained at the measuring station in the performance of the exposure steps, these patterns are accurately aligned with respect to the desired locations, and, in particular, with respect to features previously laid down on the same substrate (i.e., to ensure good overlay performance). The exposed substrate, now labeled W" is unloaded from the apparatus at step 220, to undergo etching or other processes, in accordance with the exposed pattern.

An exposure apparatus, such as that illustrated in Figure 1 or otherwise, may further comprise a transmission image sensor (TIS) system comprising a TIS plate TS on each substrate table WTa, WTb (or on the single substrate table of a single stage apparatus), which is used in combination with corresponding TIS marks at patterning device level. The transmission image sensor has a main function of aligning the patterning device support MT (and therefore the patterning device MA) with the substrate table WTa (and therefore the substrate W) on the exposure station prior to performing an exposure.

More specifically, on the measurement side, the alignment system AS measures the position, magnification and rotation of the substrate with respect to the substrate table WTa. The substrate table is the part of the substrate stage (or chuck) that carries and moves the substrate. The information (alignment data) obtained on the measurement side is then used on the exposure station.

On the exposure station, the patterning device stage MT and the patterning device MA are aligned with respect to the substrate table WTa (or WTb depending on which table is on the exposure station at that time) using the TIS plate TS. Together, the measurement side alignment and the transmission image sensor systems align the patterning device MA to the substrate W.

The overall transmission image sensor system comprises two main elements: one or more transmission image sensor plates TS on the substrate table WT and complementary TIS marks on the patterning device and/or the patterning device stage MT (e.g., on a patterning device support fiducial TSF of the patterning device stage MT). This fiducial TSF is a fixed part of the patterning device support MT, serving as a fixed reference point for, among other things, the exchangeable patterning device MA which may also comprise TIS marks. Each of the (one or more) transmission image sensor plates TS may comprise a photodetector immediately below a set of substrate table TIS marks. The patterning device level TIS marks and substrate level TIS marks may be complementary, e.g., may each comprise periodic grating structures (e.g., similar periodic grating structures). Alternatively, (at least) the substrate table TIS marks may each comprise a single aperture (e.g., single slit or rectangle).

In use, the illumination B from illumination system IL illuminates the patterning device level TIS marks (i.e., on patterning device MA and patterning device fiducial TSF), and the projection system PS captures the resultant diffraction orders from diffraction of the illumination B from these TIS marks. The diffracted light is then directed down to form an aerial image (e.g., immediately) below the projection system PS (e.g., below the objective lens of the projection system). At substrate level, the TIS plate(s) comprising one or more gratings (e.g., complementary to the patterning device level TIS marks) and photodetector(s) are arranged to sample the aerial image, e.g., such that the maximum intensity will be measured when positioning the sensor in perfect focus and alignment with the aerial image. As such, the TIS system can align the patterning device and patterning device support with the substrate support in three dimensions. In combination with the measurements of the substrate with respect to the substrate stage performed on the measurement station, this means that the relative position between patterning device and substrate is known.

A significant contributor to imaging and overlay performance of an exposure apparatus is the dynamic stability of the system. There are visual dynamic contributors to performance, such as the combined servo error of patterning device stage and substrate stage. However, there are also hidden dynamical contributors, such as chuck/stage, lens and grid-plate (e.g., fiducial) deformations. These hidden dynamic contributors result in displacements on the substrate which are not visible in the control loop, but do impact both overlay and/or critical dimension (CD) variation. These hidden dynamics are currently not directly measured; instead they are typically measured indirectly via in-resist metrology. For example, the hidden dynamics may be measured by performing exposures on a substrate coated with resist and using (e.g., scanning electron microscope SEM) metrology to measure the overlay and imaging (e.g., CD) errors generated by the hidden dynamics. These exposures may be performed similarly to production exposures, such that the hidden dynamics are similar in each case.

Measuring overlay and CD error via in-resist metrology is very time consuming, both in terms of performing the exposures, which also require dedicated scanner time and therefore a productivity impact, and metrology time. The exposed substrate needs to be fully measured via SEM metrology. SEM metrology is slow, and therefore measuring the exposed substrate(s) may take on the order of days. This means that diagnosing issues resulting from hidden dynamics takes a long time, during which yield may be lost due to the result of these dynamics being unquantified and therefore uncorrected. Also, to quantify time response improvement, a moving average filtered signal representation is typically used. As such, the in-resist metrology will capture the dynamics via the moving average filter. This moving average filtering limits the diagnostic analysis, particularly with regard to imaging error (e.g., CD errors).

Therefore, it is proposed to estimate the effect of dynamic contributors on exposure performance which result from at least one exposure apparatus action, by using the TIS system. Such an approach may comprise using the TIS system to obtain aerial image data, which can be used to estimate the effect of the dynamic contributions, while performing the at least one exposure apparatus action. The aerial image data may describe a displacement of the aerial image (e.g., with respect to the substrate stage), and may take the form of intensity data with respect to time as captured by the TIS plate photodiodes. Capturing the aerial image data while performing the exposure apparatus action may comprise using the TIS system to measure the aerial image position while the at least one exposure apparatus action is performed.

The hidden dynamic effects which are measured using the concepts disclosed herein may be excited by the dynamic exposure apparatus action. In a specific example, the exposure apparatus action may comprise the measurement station substrate stage. Other exposure apparatus actions may relate to initiating one or more fluid flows within the exposure apparatus, e.g., immersion fluid flows of an immersion exposure apparatus and/or any other fluid flows (e.g., cooling fluid or purging/contamination fluid). In the context of this disclosure, a lithographic action may include any dynamic action of a module or component of the exposure apparatus and/or a fluid therein.

This measured aerial image data can be compared or correlated with mapping data which maps aerial image data to one or more exposure performance metrics (in-resist effects) corresponding to the aerial image data. For example, a predicted exposure performance metric may comprise one or both of a predicted positional metric such as overlay error and/or an imaging metric such as CD error resultant from the dynamic contributors. In this manner, the effect on overlay and/or CD of the dynamics induced by the at least one exposure apparatus action can be quantified for each individual exposure apparatus by performing a relatively quick test (i.e., much quicker than using in-resist metrology) using the TIS system.

Once the exposure performance metric is quantified, a suitable correction can be determined which corrects for any errors described by the predicted exposure performance metric, i.e., which result from the system dynamics induced by the at least one exposure apparatus action. This correction can then be applied during production exposures (e.g., in a high volume manufacturing HVM setting) to correspond with each performance of the at least one exposure apparatus action, such that the dynamic effect of the at least one exposure apparatus action is corrected for. For example, the correction may be implemented on performance (or anticipation of planned performance) of the exposure apparatus action during an HVM exposure (or other exposure).

As an alternative to correction, or in combination with a correction, a mitigation may be determined and implemented which mitigates for the effect of the exposure apparatus action, e.g., where the effect predicted for the exposure performance metric due to the exposure apparatus action is high. For example, if the effect predicted for the exposure performance metric due to the exposure apparatus action is above a threshold indicative of a risk in yield loss, or is otherwise indicative of such a risk, then a mitigation may be determined and implemented to prevent this. Such a mitigation may comprise determining a change in the exposure apparatus action. Using the M2E example, the mitigation may comprise determining a change in the measurement station action and/or to synchronise the measurement station action with an exposure station action having a less stringent control requirement (e.g., requiring less accuracy), e.g., relatively less stringent control requirement compared to the full exposure action.

For example, an exposure station action having a less stringent control requirement may comprise a field change where the exposure moves from exposing one field on a substrate to another field on the substrate. As such, one mitigation strategy may be ensuring that a field change is synchronized with the exposure apparatus action predicted to be problematic. Alternatively, such an exposure station action may comprise exposing any field portion of a scan which has a relatively wide process window (less stringent specification), e.g., with respect to another portion of the scan. Alternatively or in addition, such an exposure station action may comprise an exposure of a field of a substrate which has a less stringent specification than another field of the substrate.

In another example, if an exposure apparatus action is predicted to result in possible yield loss or to be otherwise problematic, then the exposure apparatus action itself may be changed, e.g., in the M2E example, the measurement station action may be slowed down and/or an acceleration reduced in magnitude, or even a particular alignment mark not measured (e.g., not performing the specific problematic measurement station action).

It can be appreciated that either of these mitigation actions may have an effect on throughput (e.g., by slowing down the measurement and/or exposure). As such, a mitigation determination or optimization may take into account the process window (required specification or tolerance) in addition to the predicted effect. For example, a higher throughput may be preferred for exposure of less critical layers, accepting the predicted effect of the exposure apparatus action and therefore the mitigation applied may be small or no mitigation applied at all for these less critical layer. By contrast, for more critical layers, a larger mitigation may be performed, accepting the throughput penalty. In this way, performance can be balanced against throughput.

The mapping data may map or correlate aerial image data (i.e., TIS system data) to one or more exposure performance metrics (in-resist effects). This aerial image data may comprise intensity data describing intensity variation with time as captured by each photodetector on the TIS-plates of the TIS system during an exposure of or on at least one substrate. However, other methods of measuring the intensity image are theoretically possible and within the scope of this disclosure depending on the details of the sensor arrangement used. As such, the mapping data may be determined by exposing and measuring one or more substrates, the exposure(s) being performed simultaneously with the capture of aerial image data, such that the aerial image data can be correlated with measurements of the exposed substrate(s); e.g., correlated with measured exposure performance metric data such as overlay and/or CD data to obtain correlated aerial image data (i.e., aerial image data correlated with the overlay and/or CD data). The mapping data therefore may comprise such correlated aerial image data. The mapping data can be determined per exposure apparatus type, or per individual exposure apparatus.

This mapping data may already be available, as such mapping data may already be generated to support the TIS Frequency Diagnostics Test (FDT). The TIS FDT comprises an offline exposure apparatus calibration for measuring system dynamics (e.g., vibrations) at standstill by measuring aerial image data to capture the vibrations at standstill. As such, this aerial image measurement is made with the stages at standstill during a scan (i.e., to capture vibrations during a scan at stage standstill), with optional functionality to additionally measure scan-in effects by briefly moving the stages just before the scan. Therefore, this FDT calibration data describes the correlation between aerial image position (TIS system intensity output) and measured exposure performance metric data (in-resist error), and therefore can be used as the mapping data in the concepts disclosed herein. In this way, the proposed methods described herein comprise little additional time to be performed, e.g., per individual exposure apparatus, with no additional in-resist exposure nor SEM metrology required.

Alternatively or in addition, dedicated mapping data may be generated by exposing at least one substrate when measuring aerial position, and measuring the exposure performance metric(s) from the resultant exposed substrate(s) (e.g., using an SEM). Optionally, the exposing of the substrate may be performed simultaneously with the at least one exposure action, to ensure that aerial image data corresponding to the exposure action is captured and therefore represented in the mapping data. This dedicated mapping data may be used by itself or to supplement the aforementioned FDT calibration data.

As mentioned above, a specific example of an exposure apparatus action may comprise movement of the measurement stage (i.e., the substrate stage at the measurement side of the exposure apparatus) during exposure. This results in the so-called measure-to-expose (M2E) crosstalk effect. Movements of the measurement station (measure side) stage create pressure waves which influence hardware elements such as the lens at the exposure station (exposure side), which ultimately impacts overlay and/or imaging. This overlay and/or imaging impact manifests mainly in an increase in variation in these parameters, and is particularly pronounced when the measurement station chuck accelerates and decelerates frequently, for example during Fine Wafer Alignment (FIWA) measurements.

Another exposure apparatus action which has a M2E impact may comprise the loading of a closing substrate (closing wafer) on the measurement side, e.g., immediately after the final production wafer of a lot. Such a closing substrate may be a dummy substrate which ensures that the chuck remains loaded, which is desirable for some exposure apparatuses (e.g., immersion apparatuses). Such closing substrates may fill up gaps in or at the end of a batch/lot or substrates to be exposed by the exposure apparatus. However, these closing substrates can be responsible for a significant additional overlay/and or imaging variation in the wafer being exposed due to M2E crosstalk, over that just described.

As such, examples of an exposure apparatus action comprise a movement of the measurement substrate stage of a two-stage exposure apparatus during an exposure. For example, the lithographic action may comprise the performance or mimicking of an alignment action. For example, alignment may be performed, or one or more of the stage movements inherent in performing an alignment action (i.e., without actual measurement) may be performed, such that the measurement substrate stage is moved as it would be during an alignment action. Such an alignment action may comprise a coarse wafer alignment (COWA) and/or FIWA measurement.

Other examples an exposure apparatus action include the initiation of a fluid flow such as an immersion fluid or a purging/contamination protection fluid (e.g., which protects one or more components from contaminants). Another example of an exposure apparatus action comprises the loading of a closing substrate.

The TIS system can sample at the maximum laser repetition frequency, meaning the dynamics captured are not limited by the moving average filter as is the case for in-resist characterization of these dynamics. As such, the methods disclosed herein may comprise sampling the aerial image data at or near to the laser repetition frequency. For example, the aerial image data may be sampled at a frequency greater than 250 Hz, greater than 1kHz, greater than 2kHz, greater than 3kHz, greater than 5kHz, greater than 8kHz or greater than 10kHz (the laser repetition frequency will depend on the exposure apparatus type, for example it is much higher for an EUV apparatus than a DUV apparatus. This sampling capability means that the aerial image data can be correlated with CD variation in addition to overlay variation. As such, the aerial image data may be sampled at a first frequency (e.g., less than 250Hz) for overlay variation and/or a second frequency such as any listed above, for CD variation. Therefore, the methods are equally applicable to CD variation estimation (and therefore, depending on the control bandwidth, correction) in addition to overlay variation estimation and correction.

Another application of the concepts disclosed herein may comprise the training of a model (e.g., a machine learning or black box model) which predicts the effect of the exposure apparatus action on the at least one exposure performance metric. Such a model may comprise, for example, a neural network. The use of such a model may be particularly applicable to correction for lower frequency disturbances which can be followed by a control loop, such as the aforementioned M2E error. It is known to train a black box model to correct for M2E using in-resist data. The concepts described herein enable such a black box model to be trained without the need of in-resist data. Instead the model may be trained using aerial image data in combination with corresponding (contemporaneous) measurement station stage movement data (or other exposure apparatus action data) and the aforementioned mapping data. The model may be trained with this correlated aerial image data and corresponding measurement station stage movement data to output exposure performance metric data (e.g., overlay and/or CD error data) and/or a correction therefor based on the measurement station stage movement data/exposure apparatus action data (i.e., as performed or planned). Such a method makes it practical to train a machine specific model, instead of a system specific model as is the presently case due to the need for in-resist metrology data. As such, the model may be trained per individual apparatus or per apparatus type.

Once the model is trained, it can be used in a production setting (e.g., a high volume manufacturing setting), to map each exposure apparatus action (e.g., measurement station move) to a specific exposure station impact (e.g., overlay and/or imaging impact) or directly to a correction for the exposure station impact. This enables an exposure correction to be implemented (e.g., in a control loop) for each performance of an exposure apparatus action.

Another application may comprise evaluating new alignment marks or alignment measurement schemes without performing in-resist metrology. It can be appreciated that the measurement station actions inherent in measuring an alignment mark and/or measurement scheme may differ between different mark designs or different measurement schemes. For example, different mark sizes, scan directions and measurement schemes lead to different stage movements and therefore different effects. This means that determining an alignment mark type or measurement scheme has an M2E impact. Note that a measurement scheme in this context may comprise one or both of a placement scheme describing the placement of alignment marks on a reticle and/or a sampling scheme describing which of the exposed marks are actually measured.

Therefore, by performing an alignment measurement on a substrate with one or more marks or measurement schemes under evaluation while sampling the aerial image, the performance parameter effect of each mark/scheme can be predicted. Based on this, for example, an alignment mark or measurement scheme can be selected for which the performance parameter errors are predicted to be acceptable and/or best performing, or rejected if the predicted performance is unacceptable and/or worse performing, thereby mitigating for the predicted effect. Alternatively, or in addition, a correction and/or mitigation may be determined for the new mark or scheme as has been described. These corrections and/or mitigations are currently only considered or done on an escalation solving basis, but could potentially be integrated in software that automatically optimizes the alignment marks and corrections/mitigations therefor (e.g., with defined weights).

As such, methods disclosed herein enable the use of the TIS system to directly measure the aerial image position with respect to the substrate stage during a measurement station stage move or other exposure apparatus action, therefore capturing all in-resist dynamics resulting from this stage move/other action, and to map this aerial image to estimate the in-resist effects of the stage move/other action.

Figure 4 is a flowchart describing a method of determining a correction and/or mitigation for an effect of an exposure apparatus action of an exposure process on at least one exposure performance metric of the exposure process according to concepts disclosed herein. At step 400, aerial image data is measured, which describes a position of an aerial image projected by a projection system of an exposure apparatus. At step 410, at least one exposure apparatus action is performed simultaneously with the step 400 of measuring aerial image data, the exposure apparatus action comprising a movement of a component of the exposure apparatus and/or an initiation of a fluid flow within the exposure apparatus. At step 420 the aerial image data is correlated with the at least one exposure performance metric to obtain correlated aerial image data. At step 440, a correction (e.g., a correction to the exposure, e.g., implemented via one or both stage control and/or lens control) and/or a mitigation (e.g., to reduce the effect of the control action on the at least one exposure performance metric) is determined for the exposure process based on the correlated aerial image data.

Aspects of the invention are set out in the following clauses:
1. A method of determining a correction and/or mitigation for an effect of an exposure apparatus action of an exposure process on at least one exposure performance metric of the exposure process, comprising:
   measuring aerial image data relating to a position of an aerial image projected by a projection system of an exposure apparatus;
   performing at least one exposure apparatus action simultaneously with the step of measuring aerial image data, the exposure apparatus action comprising a movement of a component of the exposure apparatus and/or an initiation of a fluid flow within the exposure apparatus;
   correlating the aerial image data with the at least one exposure performance metric to obtain correlated aerial image data; and
   determining a correction and/or mitigation for the exposure process based on the correlated aerial image data.
2. A method according to clause 1, wherein the correlating step correlates the aerial image data with the at least one exposure performance metric and exposure apparatus action data describing the at least one exposure apparatus action.
3. A method according to clause 1 or 2, wherein the step of determining a correction and/or mitigation for the exposure process comprises determining a correction for an effect on the at least one exposure performance metric resultant from the exposure apparatus action during an exposure of a substate.
4. A method according to any preceding clause, wherein the step of determining a correction and/or mitigation for the exposure process comprises determining a mitigation which reduces or removes the effect on the at least one exposure performance metric resultant from the exposure apparatus action during an exposure of a substate.
5. A method according to clause 4, wherein the mitigation comprises a change in the exposure apparatus action.
6. A method according to clause 5, wherein the change in the exposure apparatus action comprises a change in speed and/or acceleration of the measurement station action, and/or not performing the measurement station action.
7. A method according to clause any of clauses 4 to 6, wherein the mitigation comprises a synchronization of the exposure apparatus action with an exposure station action having a relatively less stringent control requirement.
8. A method according to clause 7, wherein the mitigation comprises a synchronization of the exposure apparatus action with a field change where the exposure process moves from exposing one field on a substrate to another field on the substrate and/or an exposure of a field portion of a field which has a less stringent specification than another field portion of the field and/or an exposure of a field of a substrate which has a less stringent specification than another field of the substrate.
9. A method according to clause any of clauses 4 to 8 wherein the step of determining the mitigation is balanced against an impact on speed and/or throughput of the exposure process.
10. A method according to any of clauses 4 to 9, wherein the mitigation comprises selecting and/or rejecting one or more alignment marks and/or one or more sampling schemes based on the correlated aerial image data.
11. A method according to clause 10, comprising performing the method for one or more different alignment marks and/or measurement schemes and evaluating the effect of measuring the one or more different alignment marks and/or measurement schemes on the at least one exposure performance metric.
12. A method according to any preceding clause, wherein the step of determining a correction and/or mitigation for the exposure process comprises mapping an exposure apparatus action performed or due to be performed during the exposure to an estimated effect on the at least one exposure performance metric; and
   determining a correction and/or mitigation for the estimated effect.
13. A method according to any preceding clause, wherein the step of correlating the aerial image data with the at least one exposure performance metric comprises:
   obtaining mapping data which maps aerial image data to the at least one exposure performance metric; and
   using the mapping data to correlate the aerial image data with the at least one exposure performance metric.
14. A method according to clause 13, wherein the mapping data comprises metrology data measured from an exposed substrate and corresponding aerial image data measured during the exposure of the exposed substrate.
15. A method according to any preceding clause, comprising using the correlated aerial image data to train a model to predict the effect of exposure apparatus actions on the at least one exposure performance metric.
16. A method according to clause 15, wherein the model comprises a machine learning model.
17. A method according to clause 15 or 16, where the step of determining a correction comprises using the trained model to predict the effect of an exposure apparatus action on the at least one exposure performance metric or a correction therefor.
18. A method according to any preceding clause, wherein the aerial image data comprises intensity data over time.
19. A method according to any preceding clause, wherein the aerial image data is measured on a substrate stage at an exposure station of the exposure apparatus.
20. A method according to any preceding clause, wherein the aerial image data is measured using a transmission image sensor system.
21. A method according to any preceding clause, wherein the step of measuring aerial image data comprises diffracting exposure radiation from one or more periodic structures on a patterning device support and/or a patterning device of the exposure apparatus; projecting the diffracted exposure radiation using the projection system.
22. A method according to any preceding clause, comprising sampling the aerial image data at a frequency greater than 250Hz.
23. A method according to any preceding clause, comprising sampling the aerial image data at or near to a maximum repetition frequency of an exposure radiation source for providing exposure radiation for the exposure process.
24. A method according to any preceding clause, wherein the exposure apparatus action comprises a measurement station action comprising a movement of a component of a measurement station of the exposure apparatus.
25. A method according to clause 24, wherein the component of the measurement station comprises a substrate stage within the measurement station.
26. A method according to clause 24, wherein the exposure apparatus action comprises a loading of a closing substrate onto a substrate stage within the measurement station.
27. A method according to any of clauses 1 to 23, wherein the exposure apparatus action comprises at least one initiation of a flow of at least one fluid within the exposure apparatus.
28. A method according to clause 27, wherein the at least one fluid comprises an immersion fluid.
29. A method according to clause 27 or 28, wherein the at least one fluid comprises a purging and/or contaminant protection fluid.
30. A method according to any preceding clause, wherein the at least one exposure performance metric comprises a positional metric and/or an imaging metric.
31. A method according to any preceding clause, wherein the at least one exposure performance metric comprises overlay and/or critical dimension.
32. A method according to any preceding clause, comprising performing an exposure of a substrate using the correction and/or mitigation.
33. A computer program comprising program instructions operable to perform the method of any preceding clause, when run on a suitable apparatus.
34. A non-transient computer program carrier comprising the computer program of clause 29.
35. A processing arrangement comprising:
   the non-transient computer program carrier of clause 34; and
   a processor operable to run said computer program.
36. An exposure apparatus comprising the processing arrangement of clause 35.
37. An exposure apparatus configured to perform the method of any of clauses 1 to 32.
38. An exposure apparatus according to clause 36 or 37, comprising:
   an illumination system for providing illumination;
   a patterning device support for supporting a patterning device for patterning the illumination to obtained patterned illumination, the patterning device and/or patterning device support comprising transmission image sensor marks;
   projection optics for projecting the patterned illumination onto the substrate, and for projecting diffracted illumination from the transmission image sensor marks to form an aerial image; and
   a substrate support for supporting a substrate, the substrate support comprising a transmission image sensor for measuring the aerial image.
39. An integrated circuit manufactured using the exposure apparatus of clause 37 or 38.

In association with the hardware of the lithographic apparatus and the lithocell LC, an embodiment may include a computer program containing one or more sequences of machine-readable instructions for causing the processors of the lithographic manufacturing system to implement methods of model mapping and control as described above. This computer program may be executed for example in a separate computer system employed for the image calculation/control process. Alternatively, the calculation steps may be wholly or partly performed within a processor a metrology tool, and/or the control unit LACU and/or supervisory control system SCS of Figures 1 and 2. There may also be provided a data storage medium (e.g., semiconductor memory, magnetic or optical disk) having such a computer program stored therein in non-transient form.

Although specific reference may have been made above to the use of embodiments of the invention in the context of optical lithography, it will be appreciated that the invention may be used in other patterning applications, for example imprint lithography. In imprint lithography, topography in a patterning device defines the pattern created on a substrate. The topography of the patterning device may be pressed into a layer of resist supplied to the substrate whereupon the resist is cured by applying electromagnetic radiation, heat, pressure or a combination thereof. The patterning device is moved out of the resist leaving a pattern in it after the resist is cured.

The foregoing description of the specific embodiments will so fully reveal the general nature of the invention that others can, by applying knowledge within the skill of the art, readily modify and/or adapt for various applications such specific embodiments, without undue experimentation, without departing from the general concept of the present invention. Therefore, such adaptations and modifications are intended to be within the meaning and range of equivalents of the disclosed embodiments, based on the teaching and guidance presented herein. It is to be understood that the phraseology or terminology herein is for the purpose of description by example, and not of limitation, such that the terminology or phraseology of the present specification is to be interpreted by the skilled artisan in light of the teachings and guidance.

The breadth and scope of the present invention should not be limited by any of the above-described exemplary embodiments, but should be defined only in accordance with the following claims and their equivalents.

## Claims

1. A method of determining a correction and/or mitigation for an effect of an exposure apparatus action of an exposure process on at least one exposure performance metric of the exposure process, comprising:
measuring aerial image data relating to a position of an aerial image projected by a projection system of an exposure apparatus;
performing at least one exposure apparatus action simultaneously with the step of measuring aerial image data, the exposure apparatus action comprising a movement of a component of the exposure apparatus and/or an initiation of a fluid flow within the exposure apparatus;
correlating the aerial image data with the at least one exposure performance metric to obtain correlated aerial image data; and
determining a correction and/or mitigation for the exposure process based on the correlated aerial image data.

2. A method as claimed in claim 1, wherein the correlating step correlates the aerial image data with the at least one exposure performance metric and exposure apparatus action data describing the at least one exposure apparatus action.

3. A method as claimed in claim 1 or 2, wherein the step of determining a correction and/or mitigation for the exposure process comprises determining a correction for an effect on the at least one exposure performance metric resultant from the exposure apparatus action during an exposure of a substate.

4. A method as claimed in any preceding claim, wherein the step of determining a correction and/or mitigation for the exposure process comprises determining a mitigation which reduces or removes the effect on the at least one exposure performance metric resultant from the exposure apparatus action during an exposure of a substate.

5. A method as claimed in claim 4, wherein the mitigation comprises a change in the exposure apparatus action and/or a synchronization of the exposure apparatus action with an exposure station action having a relatively less stringent control requirement.

6. A method as claimed in claim 4 or 5, wherein the mitigation comprises selecting and/or rejecting one or more alignment marks and/or one or more sampling schemes based on the correlated aerial image data.

7. A method as claimed in claim 6, comprising performing the method for one or more different alignment marks and/or measurement schemes and evaluating the effect of measuring the one or more different alignment marks and/or measurement schemes on the at least one exposure performance metric.

8. A method as claimed in any preceding claim, wherein the step of determining a correction and/or mitigation for the exposure process comprises mapping an exposure apparatus action performed or due to be performed during the exposure to an estimated effect on the at least one exposure performance metric; and
determining a correction and/or mitigation for the estimated effect.

9. A method as claimed in any preceding claim, wherein the step of correlating the aerial image data with the at least one exposure performance metric comprises:
obtaining mapping data which maps aerial image data to the at least one exposure performance metric; and
using the mapping data to correlate the aerial image data with the at least one exposure performance metric.

10. A method as claimed in any preceding claim, comprising using the correlated aerial image data to train a model to predict the effect of exposure apparatus actions on the at least one exposure performance metric; and wherein the step of determining a correction comprises using the trained model to predict the effect of an exposure apparatus action on the at least one exposure performance metric or a correction therefor.

11. A method as claimed in any preceding claim, wherein the aerial image data comprises intensity data over time measured using a transmission image sensor system comprising at least one sensor on a substrate stage at an exposure station of the exposure apparatus.

12. A method as claimed in any preceding claim, wherein the exposure apparatus action comprises: a measurement station action comprising a movement of a component of a measurement station of the exposure apparatus; or at least one initiation of a flow of at least one fluid within the exposure apparatus.

13. A method as claimed in any preceding claim, wherein the at least one exposure performance metric comprises a positional metric and/or an imaging metric.

14. A computer program comprising program instructions operable to perform the method of any preceding claim, when run on a suitable apparatus.

15. An exposure apparatus, comprising:
an illumination system for providing illumination;
a patterning device support for supporting a patterning device for patterning the illumination to obtained patterned illumination, the patterning device and/or patterning device support comprising transmission image sensor marks;
projection optics for projecting the patterned illumination onto the substrate, and for projecting diffracted illumination from the transmission image sensor marks to form an aerial image;
a substrate support for supporting a substrate, the substrate support comprising a transmission image sensor for measuring the aerial image; and
a processor operable to perform the method of any of claims 1 to 13.
